(19) Europäisches Patentamt
European Patent Office
Office européen des brevets

(11) Veröffentlichungsnummer: **0 218 093**
**B1**

(12) **EUROPÄISCHE PATENTSCHRIFT**

(45) Veröffentlichungstag der Patentschrift: **12.12.90**

(51) Int. Cl.⁵: **C 08 G 61/02,** C 08 G 61/12, H 01 B 1/12 // C07D405/06

(21) Anmeldenummer: **86112148.1**

(22) Anmeldetag: **02.09.86**

# (54) Polymere mit konjugierten Doppelbindungen.

(30) Priorität: **04.09.85 DE 3531600**

(43) Veröffentlichungstag der Anmeldung:
**15.04.87 Patentblatt 87/16**

(45) Bekanntmachung des Hinweises auf die Patenterteilung:
**12.12.90 Patentblatt 90/50**

(84) Benannte Vertragsstaaten:
**AT BE CH DE FR GB IT LI NL SE**

(56) Entgegenhaltungen:
**EP-A-0 095 412**
**EP-A-0 099 984**
**EP-A-0 101 808**
**EP-A-0 152 632**
**WO-A-70/0678**
**FR-A-2 518 585**

(73) Patentinhaber: **WACKER-CHEMIE GMBH**
**Prinzregentenstrasse 22**
**D-8000 München 22 (DE)**

(72) Erfinder: **Bräunling, Hermann, Dr.**
**Marktlerstrasse 82**
**D-8263 Burghausen (DE)**
Erfinder: **Jira, Reinhard, Dr.**
**Heilig Kreuz 1**
**D-8263 Burghausen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 218 093 B1

**Beschreibung**

Die Erfindung betrifft Polymere mit konjugierten Doppelbindungen, die aus hetero- und/oder carbocyclischen Ringen bzw. Ringsystemen aufgebaut sind, wobei die Ringe bzw. Ringsysteme jeweils paarweise über ein Kohlenstoffatom als Brückenglied miteinander verbunden sind und das Polymere mindestens 5 dieser Ringe bzw. Ringsysteme enthält. Die erfindungsgemäßen Polymere können dadurch hergestellt werden, indem man eine oder oder mehrere Verbindungen der Formel

$$\begin{array}{c} \quad\; H \qquad\quad R \\ \quad\; | \qquad\quad\; | \\ X\text{—}C\text{—}R''\text{—}\;CX_2 \\ \quad\; | \\ \quad\; R \end{array} \qquad (I)$$

mit einer oder mehreren Verbindungen der Formel

$$H\text{—}R''\text{—}H \qquad (II)$$

gegebenenfalls unter Katalyse und/oder in einem Lösungsmittel umsetzt, wobei in den obigen Formeln X gleich oder verschiedene Fluor-, Chlor-, Brom-, Jod-, Hydroxyl-, Sulfatreste oder Reste der Formel —OR, $—SO_3F$, $—SO_3R_2$ sind oder $X_2$ für das Sauerstoffatom einer Carbonylgruppe steht; R gleiche oder verschiedene Alkylreste mit 1 bis 8 Kohlenstoffatomen, Phenylreste oder Wasserstoffatome sind, vorzugsweise Wasserstoffatome; R'' gleiche oder verschiedene, gegebenenfalls durch Kohlenwasserstoffreste mit 1 bis 8 Kohlenstoffatomen substituierte, monocyclische oder polycyclische (Hetero-) Arylenreste sind.

In den erfindungsgemäßen Polymeren müssen dabei mindestens zwei benachbarte Ringe bzw. Ringsysteme R'' strukturell unterscheiden.

Die erfindungsgemäßen Polymere können nach Dotierung mit dem Fachmann bekannten geeigneten Substanzen als elektrisch leitende bzw. halbleitende Verbindungen eingesetzt werden.

Polymere, die aus heterocyclischen bzw. carbocyclischen aromatischen Resten aufgebaut sind, sind bekannt. Polyparaphenylen und seine elektrische Leitfähigkeit nach Dotierung mit Arsenpentafluorid sind beispielsweise von W. L. Shacklette (Synthetic Metals I, 307 (1980)) beschrieben. Aus EP—A 99 984 (ausgegeben am 2. August 1984, H. Naarmann et al., BASF AG) ist die Herstellung von Copolymeren aus Pyrrol mit anderen Heterocyclen durch anodische Polymerisation in Gegenwart von Leitsalzen bekannt. Außer diesen Polyarylenen sind auch dotierte Polyarylenvinylene bekannt, wie etwa Poly-(2.5-thiophendiylvinylen) und Poly (2.5-furandiylvinylen), beispielsweise aus EP—A 101 808 (ausgegeben am 3. Juli 1984, G. Koßmehl, Bayer AG).

Die oben genannten, bereits bekannten Substanzen unterscheiden sich von den erfindungsgemäßen Polymeren dadurch, daß die (Hetero-) Arylenreste der ersteren Verbindungen jeweils paarweise direkte oder über eine Vinylgruppe miteinander verknüpft sind.

WO 87/00678 beschreibt elektrisch leitfähige Polymere, bestehend aus carbo- bzw heterozyklische, π Konjugiert Ringeinheiten, die auch über ein Kohlenstoffatom vertbrücht sein können. Die sich wiederholenden Ringeinheiten sind in diesen Polymeren strukturell gleich. Siè werden durch elektrochemische Polymerisation hergestellt.

Aufgabe der Erfindung ist es, neue Polymere mit konjugierten Doppelbindungen zur Verfügung zu stellen. Eine weitere Aufgabe der Erfindung ist es, neue, mit dem Fachmann bekannten Súbstanzen dotierte, Polymere zu Verfügung zu stellen, die nach der Dotierung elektrisch leitende bzw. halbleitende Eigenschaften zeigen. Eine weitere Aufgabe der Erfindung ist es, ein neues Verfahren zur Herstellung von Polymeren zu entwickeln, die nach Dotierungen mit dem Fachmann bekannten Substanzen elektrisch leitende bzw. halbleitende Eigenschaften zeigen. Die oben genannten Aufgaben werden im Rahmen der vorliegenden Erfindung dadurch gelöst, daß man eine oder mehrere Verbindungen der Formel (I) mit einer oder mehreren Verbindungen der Formel (II) gegebenenfalls unter Katalyse und/oder in einem Lösungsmittel umsetzt und, falls erwünscht, bei Temperaturen von 20 bis 400°C, vorzugsweise von 100 bis 300°, und Drucken von $10^{-7}$ bis 2000 Pa von flüchtigen Reaktionsprodukten, wie etwa die der Formel HX oder $H_2X_2$, und, falls anwesend, von Lösungsmittel und/oder Katalysator befreit und anschließend mit Dotierungsmittel versetzt.

Beispiele für Reste in den obigen Formeln sind Wasserstoffatome, Alkylreste wie der Methyl-, Ethyl-, n-Propyl-, iso-Propyl-, n-Butyl-, sec-Butyl-, tert.-Butyl-, n-Pentyl-, neo-Pentylrest der 2-Methylbutyl- und der 3-Methylbutylrest Hexylreste, wie der n-Hexylrest; Heptylreste, wie der n-Heptylrest; Oktylreste, wie der n-Oktyl und der 2,2,4-Trimethylpentylrest.

Bevorzugte Reste R sind Wasserstoffatome.

Beispiele für unsubstituierte (Hetero-)Arylenreste R'' sind o-, m-, und p-Phenylenreste; 2,3-, 2,4- und 2,5-Thiophendiylreste; 2,3-, 2,4- und 2,5-Pyrrolidiylreste; 2,3-, 2,4-, 2,5-Furandiylreste; 3,4- und 3,5-Pyrazoldiylreste; 2,4- und 2,5-Imidazoldiylreste; 2,4- und 2,5-Thiazoldiylreste; 3,4-und 3,5-Isothiazoldiylreste; 2,4- und 2,5-Oxazolidiylreste; 3,4- und 3,5-Isoxazolidiylreste; 2,3-, 2,4- 2,5-, 3,4-Pyridindiylreste sowie

Diylreste von Indol, Benzofuran, Benzothiophen, Chinolin, Isochinolin, Acridin, Pyridazin, Pyrimidin, Pyrazin, Chinoxalin, Naphtalin, Anthracen, Phenanthren und Phenalen.

Beispiele für die Substituenten der substituierten (Hetero-) Arylenreste R'' sind die oben für die Reste R genannten Alkylreste, des weiteren der Phenyl-, Benzyl-, o-, m-, p- Tolylreste und Xylylreste, Cycloalkylreste, wie der Cyclohexylreste und mono- und dimethylierte Cyclohexylreste, der Cyclopentyl- und der Cycloheptylrest.

Als Substituenten der substituierten (Hetero-) Arylenreste R'' sind Alkylreste mit 1 bis 8 Kohlenstoffatomen der Phenyl- und der Benzylrest bevorzugt. Von den Resten R'' sind bevorzugt gegebenenfalls mit C1 bis C8-Alkylresten oder Phenyl- oder Benzylresten substituierte Arylen- bzw. Heteroarylen- insbesondere Phenylen- und Fünfringheteroarylenreste.

Beispiele für die im erfindungsgemäßen Verfahren einsetzbare Ausgangsstoffe der Formel (I) sind

O
//
$Cl—CH_2—R''—C—H$,

O
//
$Br—CH_2—R''—C—H$,

$Cl—CH_2—R''—CHCl_2$,

$CH_3O—CH_2—R''—CHCl_2$,

$FSO_3—CH_2—R''—CHCl_2$

Beispiele für im erfindungsgemäßen Verfahren einsetzbare Ausgangsstoffe der Formel (II) sind Benzol, Toluol, Xylole, Thiophen, 2-Methylthiophen, 3-Methylthiophen, Pyrrol, N-Methylpyrrol, N-Butylpyrrole, 2-Methylpyrrol, 3-Methylpyrrol, 3,4-Dimethylpyrrol, Furan, 2-Methylfuran, 3-Methylfuran, Pyrazol, N-Methylpyrazol, N-Butylpyrazol, Imidazol, N-Methylimidazol, Thiazol, 4-Methylthiazol, Isothiazol, 4-Methylisothiazol, Imidazol Triazol, Pyridazin, Pyrazin, Oxazol, Isoxazol, Pyridin, Methylpyridine. wie α-, β-, und γ-Picoline und symmetrisches Collidin, Indol und Alkylindole, Benzofuran und Alkylbenzofurane, Benzothiophen und Alkylbenzothiophene, Chinolin, Isochinolin, Acridin, Pyridazin, Alkylpyridazine, Arylpyridazine, Pyrimidin, Alkylpyrimidine, Arylpyrimidine, Pyrazin, Alkylpyrazine, Arylpyrazine, Chinoxalin, Naphtalin, Anthracen, Phenanthren, Phenalen, Diphenyl, u.a.mehr.

Das erfindungsgemäße Verfahren zur Herstellung der erfindungsgemäßen Polymere kann in einem Lösungsmittel oder Lösungsmittelgemisch durchgeführt werden, der Zusatz von Lösungsmittel ist aber nicht zwingend erforderlich, insbesondere, wenn die Mischung der Reaktionskomponenten der Formeln (I) und (II) bereits eine klare Lösung ergibt. Beispiele für geeignete Lösungsmittel sind Dichlormethan, Trichlormethan, Tetrachlormethan, 1,2-Dichlorethan, Trichlorethylen, Schwefelkohlenstoff und Nitrobenzol.

Die Geschwindigkeit der dem erfindungsgemäßen Verfahren zugrundeliegenden chemischen Reaktion ist sehr stark von der Wahl der Reaktionspartner abhängig. Während reaktivere Aromaten, beispielsweise Pyrrol und Alkylpyrrole sich mit 5-Chlormethylfurfural in vertretbarer Zeit umsetzen lassen, ist es bei der Umsetzung von Furan mit 5-Chlormethylfurfural ratsam, die Reaktion durch einen Katalysator zu beschleunigen. Geeignete Katalysatoren sind Brønstedt-Säuren wie HCl, $H_2SO_4$, Sulfonsäuren wie Chlorsulfonsäre; Lewis-Säuren wie $BF_3$, $BF_3$-Diethyletherat, $AlCl_3$, $FeCl_3$, $SnCl_4$, $ZnCl_2$, und ähnliche. Die genannten Lewis-Säuren sind vorzugsweise wasserfrei.

Die Menge an Katalysator im Reaktionsgemisch hängt von der Aktivität der als Katalysator gewählten Brønstedt- bzw. Lewis-Säure ab. Im allgemeinen genügen Mengen von 0,01—1 Mol%, vorzugsweise von 0,1 bis 5 Molprozent an Katalysator bezogen auf die Summe der Molzahlen der Reaktionspartner der Formel (I) und (II).

Die Reaktion wird bei Temperaturen von 0 bis 250°C, vorzugsweise von 20 bis 200°C durchgeführt.

Die Reaktion kann bei erhöhtem Druck, sie kann aber auch bei erniedrigtem Druck, d.h. bei einem Druck von weniger als 0,10 MPa (abs.) durchgeführt werden. Vorzugsweise wird die Reaktion beim Druck der umgebenden Atmosphäre, also 0,102 MPa (abs.) oder etwa 0,102 MPa (abs.) durchgeführt.

Führt man die Reaktion unter Rühren in einem Lösungsmittel aus, so fallen die erfindungsgemäßen Polymere als dunkle, unschmelzbare, meist fein verteilte Niederschläge an. Beschichtungen der erfindungsgemäßen Polymere auf Oberflächen, beispielsweise Glas, Metall, Kunststoff in glatter, rauher oder gewebter Form, kann man dadurch herstellen, indem man die Reaktanten der Formel (I) und (II), gegebenenfalls Katalysator und/oder Lösungsmittel auf die Oberflächen auf trägt und dort ausreagieren läßt. Wird als Katalysator ein Gas wie etwa HCl, oder $BF_3$ verwendet, so kann die Oberfläche auch mit einer Reaktionsmischung ohne Katalysatorkompenente beschichtet werden, und das beschichtete Material anschließend in einer das Katalysatorgas enthaltenden Atmosphäre zur Reaktion gebracht werden.

Im allgemeinen werden die Reaktionskomponenten der Formel (I) und (II) im Molverhältnis 0,9 bis 1,1:1, vorzugsweise 0,99 bis 1.01:1 eingesetzt. Es kann jedoch von Vorteil sein, eine Komponente,

vorzugsweise die der Formel (II) im Überschuß einzusetzen, falls diese als Lösungsmittel fungieren soll und sie sich leicht nach der Reaktion destillativ entfernen läßt.

Nach Ablauf der Reaktion können die erfindungsgemäßen Polymere weitestgehend vom Katalysator befreit werden, z.B. durch Waschen des Niederschlags mit einem geeigneten Lösungsmittel.

Ist der Katalysator bei Raumtemperatur und 0,1 MPa gasförmig, so kann er bei Drucken unter 0,1 MPa und/oder Temperaturen über 25°C aus dem von Lösungsmittel abfiltrierten Polymeren entfernt werden. Es kann jedoch wünschenswert sein, den Katalysator im erfindungsgemäßen Polymer zu belassen, wenn dotierte Polymere mit dem Katalysator als Dotierungsmittel bzw. Leitsalz erhalten werden sollen.

Wird die Reaktion in gerührter Lösung durchgeführt, so können die Polymere nach Ablauf der Reaktion abfiltriert, gegebenenfalls vom Katalysator befreit werden.

Von den erfindungsgemäßen Polymeren bzw. den mit den erfindungsgemäßen Polymeren beschichteten Oberflächen können Lösungsmittel, falls ein solches verwandt wird, und flüchtige Reaktionsprodukte bei Drucken unterhalb 0,1 MPa und/oder Temperaturen oberhalb 25°C, vorzugsweise oberhalb 80°C abdestilliert werden.

Die erfindungsgemäßen Polymere mit konjugierten Doppelbindungen bestehen aus mindestens 5, vorzugsweise mindestens 10 Hetero-, und/oder Carbocyclischen Ringen bzw. Ringsystemen, wobei die Ringe bzw. Ringsysteme jeweils paarweise über ein Kohlenstoffatom als Brückenglied miteinander verknüpft sind. Die erfindungsgemäßen Polymere enthalten Einheiten der Formel

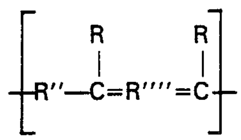

(III),

wobei R und R'' die oben angegebenen Bedeutungen haben und R'''' gleich oder verschiedene gegebenenfalls durch Kohlenwasserstoffreste mit 1 bis 8 Kohlenstoffatomen substituierte monocyclische oder polycyclische Dihydro (hetero)arendiylidenreste sind; zusätzlich zu Einheiten der Formel (III) können die erfindungsgemäßen Polymere Einheiten der Formel

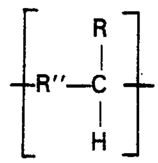

(IV)

enthalten, wobei R und R'' gleiche oder verschiedene Reste der oben angegebenen Bedeutung sind.

Beispiele für Einheiten der Formel (III) sind

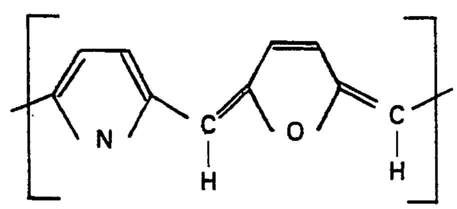

(V)

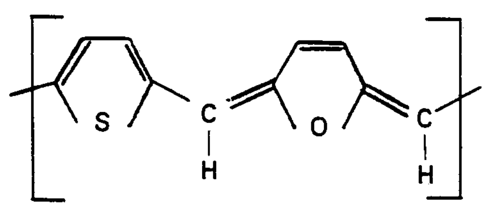

(VI)

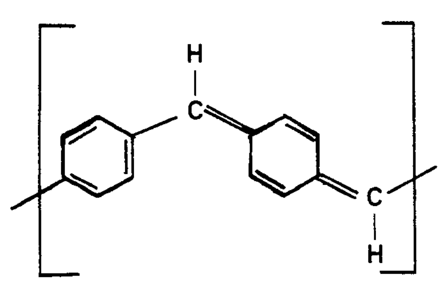

(VII)

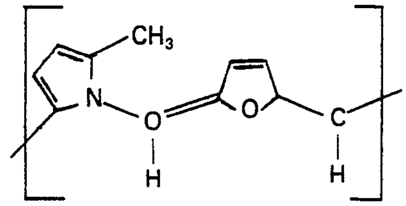

(VIII)

u.ä. mehr.

Bei geringer Reaktionsgeschwindigkeit können im erfindungsgemäßen Verfahren Zwischenprodukte isoliert werden. So wurde bei der Reaktion von 5-Chlormethylfurfural mit Imidazol die Verbindung der Formel

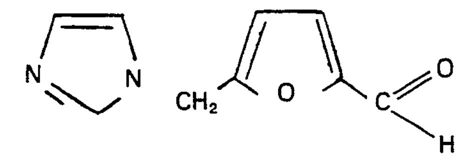

(IX)

die beim Erhitzen auf 240°C in eine schwarze glasige Masse übergeht, die nach Mahlen und Abdestillieren der flüchtigen Bestandteile ein Produkt ergibt, dessen Summenformel etwa der der Formel

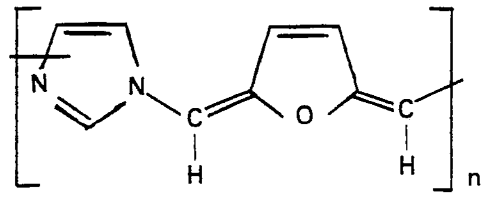

(X)

entspricht, wobei n eine ganze Zahl von mindestens 3 ist.

Falls im erfindungsgemäßen Verfahren ein Katalysator verwandt wurde und darauf verzichtet wurde, diesen nach der Reaktion weitestgehend von dem Polymer abzutrennen, können die so hergestellten Polymere bereits erhebliche elektrische Leitfähigkeit besitzen. Da der Katalysator der Wahl nicht immer das für den jeweiligen Zweck optimale Dotierungsmittel ist, wird man im allgemeinen nach Entfernung des ersteren in an sich bekannter Weise Dotierungsmittel zusetzen. Je nach Wahl der Dotierungsmittel lassen sich die Leitfähigkeiten der erfindungsgemäßen Polymere in weiten Grenzen variieren. Beispiele für Dotierungsmittel sind Alkalimetalle, wie Natrium oder Kalium; Protonensäuren wie $H_2SO_4$, $HClO_4$, $H_2Cr_2O_7$, HJ und $HNO_3$; Lewis-Säuren wie $SbCl_5$, $AsCl_5$, $TiCl_4$, $FeCl_3$, $SnCl_4$, $ZnCl_2$, $AsF_5$ und Halogen, wie z.B. Jod. Die Behandlung der erfindungsgemäßen Polymere mit Dotierungsmittel (n) wird im allgemeinen so durchgeführt, daß man die Dämpfe oder Lösungen des Dotierungsmittels auf die Polymeren einwirken läßt. Meist arbeitet man bei etwa 10 bis 30°C, meist unter Feuchtigkeitsausschluß, oft unter Luftausschluß. Die dotierten Polymere enthalten vorzugsweise von 0 bis 50, besonders vorzugsweise von 0,01 bis 30, insbesondere von 0,1 bis 20 Gewichts-% Dotierungsmittel.

In den nachfolgenden Beispielen beziehen sich die Prozentzahlen auf das Gewicht sofern nicht anders angegeben. Theoretische Analysenwerte und theoretische Ausbeute sind jeweils auf die entsprechenden Verbindungen der Formel (III) bezogen. Wie aus den Analysenwerten für Stickstoff zu entnehmen ist, enthalten die gemäß Beispiel 8 bis 19 hergestellten Polymere noch Nitrobenzol, weshalb für manche Beispiele Ausbeuten von über 100% d. Th. errechnet wurden.

## Beispiel 1

Kondensation von Pyrrol mit 5-Chlormethylfurfural:

Bei Raumtemperatur wurden 2,32 g (34,6 mmol) Pyrrol und 5 g (34,6 mmol) 5-Chlormethylfurfural in je 50 ml Chloroform gelöst, Die Lösungen wurden vereinigt, worauf sich die so entstandene Lösung nach kurzer Zeit erste grün, dann braun färbte und schließlich unter merklicher Erwärmung der Mischung ein schwarzer Niederschlag ausfiel. Das Reaktionsgemisch wurde über Nacht bei Raumtemperatur belassen, anschließend abfiltriert, das schwarze Pulver mit Chloroform gewaschen und bei Raumtemperatur und 1,3 Pa Druck getrocknet.

Ausbeute: 7,35 g;

Analyse: C 58,5%; H: 4,33%; N: 7,93%; Cl: 17,3%.

Das Produkt wurde anschließend 4 h lang bei 1,3 Pa und 250°C ausgeheizt.

| | | | | |
|---|---|---|---|---|
| Analyse: | C: 74,0%; | H: 4,4%; | N: 9,4%; | Cl: 2,5% |
| Berechnet für $(C_{10}H_7NO)_n$: | C: 76,4%; | H: 4,5%; | N: 8,9%. | |

## Beispiel 2

Kondensation von N-Methylpyrrol mit 5-Chlormethylfurfural:

Beispiel 1 wurde wiederholt mit der Abänderung, daß statt Pyrrol 1,683 g (20,7 mmol) N-Methylpyrrol und statt 5 g nur 3 g (20,7 mmol) 5-Chlormethylfurfural, jeweils gelöst in 25 ml Chloroform eingesetzt wurden.

Ausbeute: 4,14 g schwarzes Pulver;

| | | | | |
|---|---|---|---|---|
| Analyse vor dem Ausheizen: | C: 58,9%; | H: 5,12%; | N: 8,06%; | Cl: 10,7%; |
| Analyse nach Ausheizen: | C: 77,6%; | H: 5,30%; | N: 9,30%; | Cl: 0,5%; |
| Berechnet für $(C_{11}H_9NO)_n$: | C: 77,2%; | H: 5,30%; | N: 5,2%. | |

Beispiel 3

Kondensation von 2-Methylpyrrol mit 5-Chlormethylfurfural:

Beispiel 1 wurde wiederholt mit der Abänderung, daß statt Pyrrol 1,683 g (20,7 mmol) 2-Methylpyrrol und statt 5 g 3 g (20,7 mmol) 5-Chlormethylfurfural eingesetzt wurden.

Ausbeute: 4,9 g schwarzes Pulver;

| | | | | |
|---|---|---|---|---|
| Analyse vor dem Ausheizen: | C: 57,4%; | H: 5,5%; | N: 6,3%; | Cl: 12,2%; |
| Analyse nach dem Ausheizen: | C: 68,3%; | H: 5,1%; | N: 7,7%; | Cl: 0,5%; |
| Berechnet für $(C_{11}H_9NO)_n$: | C: 77,2%; | H: 5,3%; | N: 8,2%. | |

Beispiel 4

Kondensation von N-Butylpyrrol mit 5-Chlormethylfurfural:

Eine Lösung von 2,556 g (20,7 mmol) 1-n-Butylpyrrol und 3 g (20,7 mmol) 5-Chlormethylfurfural in 100 ml Chloroform wurde mit 2 bis 3 Gasblasen HCl-Gas versetzt. Man hielt das Gemisch 18 Stunden lang bei Raumtemperatur und anschließend 4 Stunden bei 50°C. Es wurde wie in Beispiel 1 aufgearbeitet.

Ausbeute: 4,92 g eines schwarzen, schwammigen Feststoffes;

| | | | | |
|---|---|---|---|---|
| Analyse vor dem Ausheizen: | C: 61,7%; | H: 7,1%; | N: 6,1%; | Cl: 13,0%; |
| Analyse nach dem Ausheizen: | C: 78,3%; | H: 7,7%; | N: 8,2%; | Cl: 1,8%; |
| Berechnet für $(C_{14}H_{15}NO)_n$: | C: 78,8%; | H: 7,1%; | N: 6,6%. | |

Beispiel 5

Kondensation von Furan mit 5-Chlormethylfurfural:

Eine Lösung von 3,35 g (34,6 mmol) Furan und 5 g (34,6 mmol) 5-chlormethylfurfural in 50 ml Chloroform wurde mit 0,1 ml $BF_3$-Diethyletherat versetzt, 4 h bei Raumtemperatur belassen und anschließend 12 h bei 50°C gehalten. Es wurde wie in Beispiel 1 aufgearbeitet.

Ausbeute: 4,06 g schwarzes Pulver;

| | | | |
|---|---|---|---|
| Analyse vor dem Aufheizen: | C: 65,0%; | H: 3,92%; | Cl: 5,4%; |
| Analyse nach dem Aufheizen: | C: 76,2%; | H: 4,4%; | Cl: 0,5%; |
| Berechnet für $(C_{14}H_6O_2)_n$: | C: 75,9%; | H: 3,8%. | |

Beispiel 6

Kondensation von Thiophen mit 5-Chlormethylfurfural:

Beispiel 5 wurde wiederholt mit der Abänderung, daß statt Furan 3,64 g (34,6 mmol) Thiophen, statt 50 ml nur 20 ml Chloroform eingesetzt wurden und die Mischung 8 h unter Rückfluß gekocht wurde.

Ausbeute: 3,36 g eines schwarzen Pulvers;

| | | | |
|---|---|---|---|
| Analyse nach dem Ausheizen: | C: 65,0%; | H: 3,3%; | S: 15,6%; |
| Berechnet für $(C_{10}H_6SO)_n$: | C: 68,9%; | H: 3,5%; | S: 18,4%. |

Beispiel 7

Gießen von Folien:

Einer Lösung von 360 mg (2,5 mmol) 5-Chlormethylfurfural in 5 ml Diethylether wurden bei 0°C 202 mg (2,5 mmol) N-Methylpyrrol zugegeben. Die so hergestellte Lösung wurde auf eine durch 1 mm dicke Glasstreifen begrenzte Glasoberfläche von 7,4 × 10,4 cm gegossen. Nach 0,5 h Stehenlassen bei Raumtemperatur war das Lösungsmittel weitgehend verdampft und auf der Glasoberfläche hatte sich ein schwarzer glänzender Film abgeschieden.

Beispiel 8

Umsetzung von Benzol mit α,α,α'-Trichlor-p-Xylol:

Eine Lösung von 20 g (95,5 mmol) α,α,α'-Trichlor-p-xylol und 7,46 g (95,5 mmol) Benzol in 100 ml wasserfreiem Nitrobenzol wurde zu einer Lösung von 1 g wasserfreiem $AlCl_3$ in 100 ml wasserfreiem Nitrobenzol bei 100°C unter Rühren innerhalb von 45 min zugetropft. Nach 1,5 h Halten des Gemisches auf 192 bis 202°C hatte die HCl-Entwicklung aufgehört und das Gemisch war zu einer gallertartigen Masse erstarrt. Der Rückstand wurde viermal mit je 400 ml Ethanol in einem Ultra- Turrax Type TP 18/10 (Hersteller: Janke & Kunkel, D—7813 Staufen) zerkleinert, durchgerührt und abgesaugt. Der schwarze Rückstand wurde 2 Tage an der Luft und im Exciccator über KOH bei 13 Pa, jeweils bei Raumtemperatur, getrocknet.

Ausbeute: 16,4 g schwarzes Pulver;

Nach dem Ausheizen gemäß Beispiel 1:

Ausbeute: 14,8 g (87% d.Th.) schwarzes Pulver.

| | | | | |
|---|---|---|---|---|
| Analyse nach dem Ausheizen: | C: 89,4%; | H: 5,13%; | N: 1,0%; | Cl: 1,5%; |
| Berechnet für $(C_{14}H_{10})_n$: | C: 94,35%; | H: 5,65%. | | |

Beispiel 9

Umsetzung von Benzol mit α,α,α'-Trichlor-p-xylol:

Beispiel 8 wurde wiederholt mit der Abänderung, daß statt 1,5 h bei 192 bis 202°C 24 h bei 120°C erhitzt wurde.

Ausbeute Nach dem Ausheizen: 14,3 g (84,2% d. Th.) schwarzes Pulver
Analyse nach dem Ausheizen: C: 90,10%; H: 5,80%; Cl: 1,1%; N: 0,6%;
Berechnet für $(C_{14}H_{10})_n$: C: 94,35%; H: 5,65%.

Beispiel 10

Umsetzung von p-Xylol mit α,α,α'-Trichlor-p-xylol:

Beispiel 8 wurde wiederholt mit der Abänderung, daß statt Benzol 10,13 g (95,5 mmol) p-Xylol eingesetzt wurde.

Ausbeute nach dem Ausheizen: 19,29 g (98% d.Th.) dunkelbraunes Pulver;
Analyse nach dem Ausheizen: C: 88,9%; H: 5,13%; N: 0,87%; Cl: 1,0%;
Berechnet für $(C_{16}H_{14})_n$: C: 93,2%; H: 6,8%.

Beispiel 11

Umsetzung von Thiophen mit α,α,α'-Trichlor-p-xylol:

Beispiel 8 wurde wiederholt mit der Abänderung, daß statt Benzol 8,02 g (95,5 mmol) Thiophen eingesetzt wurde.

Ausbeute nach dem Ausheizen: 16,2 g (86% d.Th.) dunkelbraunes Pulver.
Analyse nach dem Ausheizen: C: 76,1%; H: 4,04%; N: 3,04%; S: 11,36%; Cl: 1,9%;
Berechnet für $(C_{12}H_8S)_n$: C: 78,2%; H: 4,38%; S: 17,4%.

Beispiel 12

Umsetzung von o-Xylol mit α,α,α'-Trichlor-p-Xylol:

Beispiel 8 wurde wiederholt mit der Abänderung, daß statt Benzol 10,13 g (95,5 mmol) o-Xylol eingesetzt wurden.

Ausbeute nach dem Ausheizen: 19,08 g (96,9% d.Th.) dunkelbraunes Pulver;
Analyse nach dem Ausheizen: C: 90,6%; H: 7,0%; N: 1,8%; Cl: <0,1%;
Berechnet für $(C_{16}H_{14})_n$: C: 93,2%; H: 6,8%.

Beispiel 13

Umsetzung von m-Xylol mit α,α,α'-Trichlor-p-xylol:

Beispiel 12 wurde wiederholt mit der Abänderung, daß staff o-Xylol die gleiche Menge am m-Xylol eingesetzt wurde.

Ausbeute nach dem Ausheizen: 20,79 g (105,7% d.Th.) dunkelbraunes Pulver;
Analyse nach dem Ausheizen: C: 89,9%; H: 7,2%; N: 2,2%; Cl: <0,1%;
Berechnet für $(C_{16}H_{14})_n$: C: 93,2%; H: 6,8%.

Beispiel 14

Umsetzung von p-Xylol mit α,α,α'-Trichlor-p-xylol:

Beispiel 8 wurde wiederholt mit der Abänderung, daß statt 20 g nur 5 g (23,9 mmol) α,α,α'-Trichlor-p-xylol, statt Benzol 2,533 g (23,9 mmol) p-Xylol, statt jeweils 100 ml nur jeweils 50 ml Nitrobenzol und statt wasserfreiem $AlCl_3$ 250 mg wasserfreies $FeCl_3$ eingesetzt wurden.

Ausbeute nach dem Ausheizen: 4,81 g (97,8% d.Th.,) schwarzes Pulver;
Analyse nach dem Ausheizen: C: 88,8%; H: 6,8%; N: 1,23%; Cl: <0,1%;
Berechnet für $(C_{16}H_{14})_n$: C: 93,2%; H: 6,8%.

Beispiel 15

Umsetzung von p-Xylol mit α,α,α'-Trichlor-p-xylol:

Beispiel 14 wurde wiederholt mit der Abänderung, daß statt wasserfreiem $FeCl_3$ 250 mg wasserfreies $SnCl_4$ eingesetzt wurde.

Ausbeute nach dem Ausheizen: 4,98 g (101,2% d.Th.) schwarzes Pulver;
Analyse nach dem Ausheizen: C: 90,3%; H: 7,1%; N: 1,58%; Cl: 0,2%;
Berechnet für $(C_{16}H_{14})_n$: C: 93,2%; H: 6,8%.

Beispiel 16

Umsetzung von Diphenyl mit α,α,α'-Trichlor-p-xylol:

Beispiel 8 wurde wiederholt mit der Abänderung, daß statt Benzol 14,72 g (95,5 mmol) Diphenyl eingesetzt wurde.

Ausbeute nach dem Ausheizen: 23,2 g (95,7% d.Th.) graubraunes Pulver;
Analyse nach dem Ausheizen: C: 92,6%; H: 5,65%; N: 1,33%; Cl: 0,1%;
Berechnet für $(C_{20}H_{14})_n$: C: 94,45%; H: 5,55%.

Beispiel 17

Umsetzung von Diphenylmethan mit α,α,α'-Trichlor-p-xylol:

Beispiel 8 wurde wiederholt mit der Abänderung, daß statt Benzol 16,06 g (95,05 mmol) Diphenylmethan eingesetzt wurde. Ausbeute nach dem Ausheizen: 22,48 g (87,8% d. Th.) braunes Pulver;

Ausbeute nach dem Ausscheizen: 4,81 g :(97,8% d.Th.,) schwarzes Pulver;

| | |
|---|---|
| Analyse nach dem Ausheizen: | C: 91,5%; H: 6,2%; N: 1,0%; Cl: 0,1%; |
| Berechnet für $(C_{21}H_{16})_n$: | C: 94,0%; H: 6,0%. |

Beispiel 18

Umsetzung von Naphtalin mit α,α,α'-Trichlor-p-xylol:

Beispiel 8 wurde wiederholt mit der Abänderung, daß statt Benzol 12,23 g (95,5 mmol) Naphtalin eingesetzt wurde.

Ausbeute nach dem Ausheizen: 22,05 g (101,2% d.Th.) graubraunes Pulver;

| | |
|---|---|
| Analyse nach dem Ausheizen: | C: 90,97; H: 5,80%; N: 2,33%; Cl: 0,1%; |
| Berechnet für $(C_{18}H_{12})_n$: | C: 94,7%; H: 5,30%. |

Beispiel 19

Umsetzung von Anthracen mit α,α,α'-Trichlor-p-xylol:

Eine Lösung von 20 g (95,5 mmol) α,α,α'-Trichlor-p-xylol und 17,01 g (95,5 mmol) Anthracen in 100 ml wasserfreiem Nitrobenzol wurde zu einer Lösung von 1 g wasserfreiem $AlCl_3$ in 100 ml wasserfreiem Nitrobenzol bei 100°C unter Rühren innerhalb von 45 min zugetropft. Nach 1,5 h Halten des Gemisches auf 192°C bis 202°C hatte die HCl-Entwicklung aufgehört. Der schwarze Niederschlag wurde abfiltriert und dreimal mit je 100 ml Nitrobenzol und dreimal mit je 100 ml Methanol gewaschen und bei Raumtemperatur und 1,3 Pa Druck über KOH 12 h getrocknet. Das Produkt wurde anschließend 4 h lang bei 1,3 Pa und 250°C ausgeheizt.

Ausbeute: 12,86 g (48,4% d.Th.) schwarzes Pulver;

| | |
|---|---|
| Analyse: | C: 92,3%; H: 5,3%; N: 0,9%; Cl: 0,1%; |
| Berechnet für $(C_{22}H_{14})_n$: | C: 94,9%; H: 5,1%; |

Das Filtrat wurde mit der Waschflüssigkeit vereinigt und mit 2 l Methanol versetzt, worauf ein flockiger, dunkelbrauner Niederschlag ausfiel. Dieser wurde abfiltriert, dreimal mit je 100 ml Methanol gewaschen und wie oben im selben Beispiel geschildert, getrocknet und ausgeheizt.

Ausbeute: 11,8 g (44,6% d.Th.) schwarzes Pulver;

| | |
|---|---|
| Analyse: | C: 92,4%; H: 5,4%; N: 1,7%; Cl: %; |
| Berechnet für $(C_{22}H_{14})_n$: | C: 94,9%; H: 5,1%. |

Beispiel 20

Kondensation von Imidazol mit 5-Chlormethylfurfural:

a) Darstellung von 5-(1-Imidazolyl)-methylfurfural (IX):

Fine Lösung von 3 g (20,8 mmol) 5-Chlormethylfurfural und 1,41 g (20,8 mmol) Imidazol in 25 ml Chloroform wurde 4 h lang unter Rückfluß erhitzt. Nach Abkühlen der Lösung wurde mit wässriger Bicarbonatlösung und Wasser gewaschen und bei 2000 Pa und 80°C Lösungsmittel abgezogen.

Ausbeute: 3,25 g (89% d. Th.) zähflüssiges Öl der Formel (IX):

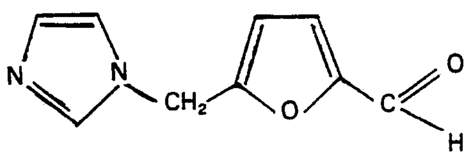

(IX)

$^1$H—NMR (360 MHz): 5,25 ppm s ($CH_2$-Gruppe); 6,49 ppm d (J = 4,8 Hz); 7,8 ppm s; 7,15 ppm s; 7,26 ppm d (J = 4,8 Hz); 7,67 ppm s; 9,63 ppm s.

b) Polykondensation von Imidazol mit 5-Chlormethylfurfural:

Der unter a) beschriebene Versuch wurde wiederholt, mit der Abänderung, daß vor Erhitzen des Reaktionsgemisches 0,1 ml $BF_3$-Diethyletherat zugegeben und 8 h lang unter Rückfluß erhitzt wurde; nach Abdampfen des Lösungsmittels wie unter a) wurde der verbleibende zähe Rückstand unter Argonatmosphäre erhitzt, wobei die Temperatur innerhalb 4 h von 100°C auf 240°C gesteigert und anschließend weitere 2 h bei 240°C gehalten wurde.

Ausbeute: 4,16 g glasiger, schwarzglänzender schaumiger Feststoff;

Das Produkt wurde anschließend fein gemahlen und 3,5 g davon bei 250°C und 1,3 Pa 4 h lang ausgeheizt.

Ausbeute: 1,98 g (71,6% d.Th.) schwarzes Pulver;

| | |
|---|---|
| Analyse: | C: 64,5%; H: 3,4%; N: 11,2%; Cl: 2,8%; |
| Berechnet für $(C_9H_6N_2O)_n$: | C: 68,3%; H: 3,8%; N: 17,7%. |

Beispiel 21

Dotierung der Polymere:

Die in den vorangegangenen Beispielen erhaltenen Produkte wurden zusammen mit einer gewogenen Menge an Jod in einem Schlenkrohr unter Außenkühlung von flüssigem Stickstoff abgekühlt bis auf einen Restdruck von 1,3 Pa evakuiert, auf Raumtemperatur aufgewärmt und 24 h lang bei 120°C belassen. folgende Tab. 1 verzeichnet den Jodgehalt der auf diese Weise dotierten Polymere im Vergleich zu den entsprechenden undotierten Produkten.

TAB. 1

| Polymer gemäß Beispiel nr. | Im Beispiel eingesetzte Reaktanten* | Jodgehalt (%) Gef. | Ber. | Leitfähigkeit (S/cm) |
|---|---|---|---|---|
| 1 | A, Pyrrol | — | 0,00 | $4,6 \times 10^{-9}$ |
| | | — | 7,42 | $2,2 \times 10^{-8}$ |
| | | 8,60 | 13,90 | $9,2 \times 10^{-8}$ |
| | | 10,20 | 24,41 | $4,3 \times 10^{-7}$ |
| | | 32,50 | 39,24 | $7,8 \times 10^{-7}$ |
| | | 52,50 | 56,36 | $9,6 \times 10^{-7}$ |
| | | 64,00 | 72,10 | $9,2 \times 10^{-6}$ |
| 2 | A, N-Methylpyrrol | — | 0,00 | $5,3 \times 10^{-10}$ |
| | | — | 7,50 | $1,5 \times 10^{-9}$ |
| 5 | A, Furan | — | 0,00 | $<1,0 \times 10^{-9}$ |
| | | — | 6,9 | $1,5 \times 10^{-6}$ |
| | | 12,90 | 13,83 | $2,3 \times 10^{-6}$ |
| | | 25,90 | 24,30 | $3,5 \times 10^{-5}$ |
| | | 36,10 | 39,71 | $1,0 \times 10^{-4}$ |
| | | 52,10 | 56,21 | $1,2 \times 10^{-4}$ |
| 8 | B, Benzol | — | 0,00 | $<1,0 \times 10^{-11}$ |
| | | 2,0 | 3,44 | $<1,0 \times 10^{-11}$ |
| | | 8,3 | 6,65 | $<1,0 \times 10^{-11}$ |
| | | 10,7 | 12,47 | $5,0 \times 10^{-11}$ |
| | | 16,5 | 22,17 | $4,0 \times 10^{-10}$ |
| | | 36,0 | 36,29 | $7,0 \times 10^{-8}$ |
| 10 | B, p-Xylol | — | 0,00 | $<1,0 \times 10^{-11}$ |
| | | 3,1 | 2,98 | $<1,0 \times 10^{-11}$ |
| | | 5,9 | 5,80 | $<1,0 \times 10^{-11}$ |
| | | 10,0 | 10,96 | $<1,0 \times 10^{-11}$ |
| | | 21,7 | 19,75 | $9,0 \times 10^{-11}$ |
| | | 31,0 | 32,98 | $6,0 \times 10^{-8}$ |
| 11 | B, Thiophen | — | 0,00 | $4,0 \times 10^{-10}$ |
| | | 3,0 | 3,33 | $7,0 \times 10^{-10}$ |
| | | 4,2 | 6,44 | $2,0 \times 10^{-9}$ |
| | | 9,1 | 12,10 | $1,5 \times 10^{-8}$ |
| | | 15,1 | 21,79 | $6,0 \times 10^{-8}$ |
| | | 31,0 | 35,53 | $1,1 \times 10^{-7}$ |

* A: 5-Chlormethylfurfural; B: α,α,α'-Trichlor-p-xylol

Beschreibung der Zeichnungen

Nachstehend sind IR-Spektren von KBr-Preßlingen von drei der erfindungsgemäßen Polymere und $^{13}C$-Festkörperkernspinresonanzspektren (75,46 MHz) von zwei der erfindungsgemäßen Polymere abgebildet. (Gerät: Bruker MSL—300)

Fig. 1: IR-Spektrum des bei 250°C und 1,3 Pa ausgeheizten Polymers hergestellt gemäß Beispiel 1.
Fig. 2: IR-spektrum des bei 1,3 Pa getrockneten Polymers gemäß Beispiel 8.
Fig. 3: IR-Spektrum des bei 1,3 Pa getrockneten Polymers gemäß Beispiel 11.
Fig. 4: $^{13}C$-Festkörper-NMR-Spektrum des Polymers gemäß Beispiel 8.
Fig. 5: $^{13}C$-Festkörper-NMR-Spektrum des Polymers gemaß Beispiel 11.
In Fig. 1, Fig. 2 und Fig. 3 sind von rechts nach links die Wellenzahlen in $cm^{-1}$ aufgetragen.

In Fig. 4 und Fig. 5 sind von rechts nach links die chemischen Verschiebungen in ppm relativ zu $(CH_3)_4$ Si aufgetragen.

**Patentansprüche für die Vertragsstaaten: BE CH DE FR GB IT LI NL SE**

1. Polymere mit konjugierten Doppelbindungen, die aus hetero- und/oder carbocyclischen Ringen bzw. Ringsystemen aufgebaut sind, dadurch gekennzeichnet, daß die Ringe bzw. Ringsysteme jeweils paarweise über ein Kohlenstoffatom als Brückenglied miteinander verbunden sind und die Polymere mindestens 5 dieser Ringe bzw. Ringsysteme und von 0—50 Gewichts-% Dotierungsmittel enthalten, wobei sich mindestens zwei benechbarte Ringe bzw. Ringsysteme strukturell unterscheiden.

2. Polymere gemäß Anspruch 1, dadurch gekennzeichnet, daß sie von 0,01 bis 30 Gewichts-% Dotierungsmittel enthalten.

3. Polymere gemäß Anspruch 1) oder 2) dadurch gekennzeichnet, daß sie Einheiten der Formel

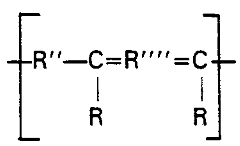

enthalten, worin

R gleiche oder verschiedene Alkylreste mit 1 bis 8 Kohlenstoffatomen, Phenylreste oder Wasserstoffatome;

R″ gleiche oder verschiedene, gegebenenfalls durch Kohlenwasserstoffreste mit 1 bis 8 Kohlenstoffatomen substituierte monocyclische oder polycyclische (Hetero-) Arylenreste:

R″″ gleiche verschiedene gegebenenfalls durch Kohlenwasserstoffreste mit 1 bis 8 Kohlenstoffatomen substituierte monocyclische oder polycyclische Dihydro(hetero)arendiylidenreste bedeuten.

4. Verfahren zur Herstellung von Polymeren dadurch gekennzeichnet, daß man eine oder mehrere Verbindungen der Formel (I)

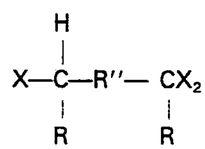

(I)

mit einer oder mehreren Verbindungen der Formel (II)

H—R″—H (II)

gegebenenfalls unter Katalyse und/oder in einem Lösungsmittel umsetzt, wobei in den obigen Formeln

X gleich oder verschiedene Fluor-, Chlor-, Brom-, Jod-, Hydroxyl-, Sulfatreste oder Reste der Formel —OR, $—SO_3F$, $—SO_3R$, $—NR_2$ sind, oder

$X_2$ für das Sauerstoffatom einer Carbonylgruppe steht, und R und R″ die in Anspruch 3 angegebene Bedeutung haben.

5. Verfahren zur Herstellung von dotierten Polymeren dadurch gekennzeichnet, daß man die nach dem Verfahren gemäß Anspruch 4 hergestellten Polymere bei Temperaturen von 20 bis 400°C und Drucken von $10^{-7}$ bis 2000 Pa behandelt und anschließend mit Dotierungsmittel versetzt.

6. Verwendung der Polymere gemäß Anspruch 1, 2 oder 3, bzw. der nach dem Verfahren gemäß Anspruch 4 oder 5 hergestellten Polymere als elektrisch leitende bzw. elektrisch halbleitende Verbindungen.

**Patentansprüche für den Vertragsstaat: AT**

1. Verfahren zur Herstellung von Polymeren dadurch gekennzeichnet, daß man eine oder mehrere Verbindungen der Formel (I)

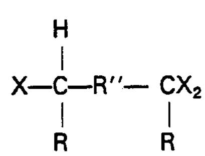

(I)

mit einer oder mehreren Verbindungen der Formel (II)

H—R″—H (II)

gegebenenfalls unter Katalyse und/oder in einem Lösungsmittel umsetzt, wobei in den obigen Formeln

X gleich oder verschiedene Fluor-, Chlor-, Brom-, Jod-, Hydroxyl-, Sulfatreste oder Reste der Formel —OR, $—SO_3F$, $—SO_3R$, $—NR_2$ sind, oder

$X_2$ für das Sauerstoffatom einer Carbonylgruppe steht,

R gleiche oder verschiedene Alkylreste mit 1 bis 8 Kohlenstoffatomen, Phenylreste oder Wasserstoffatome;

R'' gleiche oder verschiedene, gegebenenfalls durch Kohlenwasserstoffreste mit 1 bis 8 Kohlenstoffatomen substituierte monocyclische oder polycyclische (Hetero-) Arylenreste; bedeuten.

2. Verfahren zur Herstellung von dotierten Polymeren dadurch gekennzeichnet, daß man die nach dem Verfahren gemäß Anspruch 4 hergestellten Polymere bei Temperaturen von 20 bis 400°C und Drucken von $10^{-7}$ bis 2000Pa behandelt und anschließend mit Dotierungsmittel versetzt.

3. Verwendung der nach dem Verfahren gemäß Anspruch 1 oder 2 hergestellten Polymere als elektrisch leitende bzw. elektrisch halbleitende Verbindungen.

**Revendications pour les Etats contractants: FR BE CH DE GB IT LI NL SE**

1. Polymères à doubles liaisons conjuguées formés de cycles ou systèmes cycliques hétérocycliques et/ou carbocycliques, polymères caractérisés en ce que les cycles ou systèmes cycliques sont reliés par paires entre eux par un atome de carbone formant pont, en ce que ces polymères comportent au moins cinq de ces cycles ou systèmes cycliques et en ce qu'ils contiennent de 0 à 50% en poids d'agents de dopage, au moins deux cycles ou systèmes cycliques voisins se différenciant par leur structure.

2. Polymères selon la revendication 1, caractérisés en ce qu'ils contiennent de 0,01 à 30% en poids des agents de dopage.

3. Polymères selon la revendication 1 ou 2, caractérisés en ce qu'ils comprennent des motifs de formule:

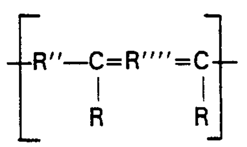

dans lesquels:

R représente des radicaux identiques ou différents, à savoir alkyles en $C_1$ à $C_8$, phényles ou d'atomes d'hydrogène,

R'' représente des radicaux arylènes ou hétéroarylènes monocycliques ou polycycliques identiques ou différents éventuellement substitués par des groupes hydrocarbonés en $C_1—C_8$; et

R'''' représente des radicaux dihydro-(hétéro)-arène-diylidènes monocycliques ou polycycliques identiques ou différents dans les divers motifs, éventuellement substitués par des groupes hydrocarbonés en $C_1$ à $C_8$.

4. Procédé de préparation de polymères, procédé caractérisé en ce que l'on fait réagir un ou plusieurs composés de formule I ci-dessous;

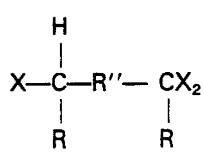

(I)

avec un ou plusieurs composés de formule II:

H—R''—H (II)

éventuellement en présence d'un catalyseur et/ou dans un solvant, formules dans lesquelles:

les X représentent des radicaux identiques ou différents, de fluor, chlore, brome ou iode, radicaux hydroxyliques, sulfates ou —OR, $—SO_3F$, $—SO_3R$ ou $—NR_2$, ou bien

$X_2$ représente l'atome d'oxygène d'un groupe carbonyle, et

R et R'' ont les significations qui ont été données à la revendication 3.

5. Procédé de préparation de polymères dopés, caractérisé en ce que l'on traite les polymères qui ont été obtenus par le procédé de la revendication 4 à des températures de 20 à 400°C et à des pressions de $10^{-7}$ à 2 000 Pa, puis on leur ajoute un agent de dopage.

6. Emploi des polymères suivant la revendication 1, 2 ou 3, ou qui ont été obtenus par le procédé de la revendication 4 ou 5, comme matériaux électroconducteurs ou semi-conducteurs.

**Revendications pour l'Etat contractant: AT**

1. Procédé de préparation de polymères, caractérisé en ce que l'on fait réagir un ou plusieurs composés de formule I ci-dessous;

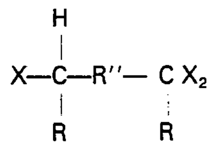

(I)

avec un ou plusieurs composés de formule II:

$$H—R''—H \qquad (II)$$

éventuellement en présence d'un catalyseur et/ou dans un solvant, formules dans lesquelles:

les X représentent des radicaux identiques ou différents, de fluor, chlore, brome ou iode, radicaux hydroxyliques, sulfates ou —OR, $—SO_3F$, $—SO_3R$ ou $—NR_2$, ou bien

$X_2$ représente l'atome d'oxygène d'un groupe carbonyle,

R représente des radicaux identiques ou différents, à savoir alkyles en $C_1$ à $C_8$, phényles ou d'atomes d'hydrogène, et

R'' des radicaux arylènes ou hétéroarylènes monocycliques ou polycycliques identiques ou différents, éventuellement substitués par des groupes hydrocarbonés en $C_1$—$C_8$.

2. Procédé de préparation de polymères dopés, procédé caractérisé en ce que l'on traite les polymères qui ont été obtenus par le procédé de la revendication 1 à des températures de 20 à 400°C et à des pressions de $10^{-7}$ à 2000 Pa, puis on leur ajoute un agent de dopage.

3. Emploi des polymères qui ont été obtenus par le procédé de la revendication 1 ou 2, comme matériaux électroconducteurs ou semiconducteurs.

**Claims for the Contracting States: BE CH DE FR GB IT LI NL and SE**

1. Polymers which have conjugated double bonds and are composed of hetero- and/or carbo-cyclic rings or ring systems, characterized in that the rings or ring systems are bonded together in pairs in each case via a carbon atom which acts as the bridging member and the polymers contain at least 5 of these rings or ring systems and from 0—50% by weight of dopant, and at least two adjacent rings or ring systems differ in structure.

2. Polymers according to Claim 1, characterized in that they contain from 0.01 to 30% by weight of dopant.

3. Polymers according to Claim 1 or 2, characterized in that they contain units of the formula

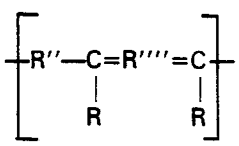

in which

R are identical of different alkyl radicals having 1 to 8 carbon atoms, phenyl radicals or hydrogen atoms;

R'' are identical or different, monocyclic or polycyclic (hetero-)arylene radicals which are optionally substituted by hydrocarbon radicals having 1 to 8 carbon atoms;

R'''' are identical or different, monocyclic or polycyclic dihydro-(hetero)arenediylidene radicals which are optionally substituted by hydrocarbon radicals having 1 to 8 carbon atoms.

4. Process for the preparation of polymers, characterized in that one or more compounds of the formula (I)

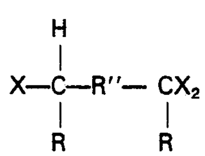

(I)

are reacted with one or more compounds of the formula (II)

$$H—R''—H \qquad (II)$$

optionally under catalysis and/or in a solvent, and in the above formulae

X are identical or different fluorine, chlorine, bromine, iodine, hydroxyl or sulphate radicals or radicals of the formula —OR, —$SO_3F$, —$SO_3R$, or —$NR_2$, or

$X_2$ represents the oxygen atom of a carbonyl group, and R and R'' having the meaning given in Claim 3.

5. Process for the preparation of doped polymers, characterized in that the polymers which have been prepared by the process according to Claim 4 are treated at temperatures from 20 to 400°C and pressures from $10^{-7}$ to 2000 Pa and then dopant is added to these polymers.

6. The use of polymers according to Claim 1, 2 or 3, or of the polymers prepared by the process according to Claim 4 or 5 as electrically conducting or electrically semi-conducting compounds.

**Claims for the Contracting State: AT**

1. Process for the preparation of polymers, characterized in that one or more compounds of the formula (I)

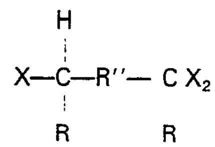

(I)

are reacted with one or more compounds of the formula (II)

$$H—R''—H \qquad (II)$$

optionally under catalysis and/or in a solvent, and in the above formulae

X are identical or different fluorine, chlorine, bromine, iodine, hydroxyl or sulphate radicals or radicals of the formula —OR, —$SO_3F$, —$SO_3R$, or —$NR_2$, or

$X_2$ represents the oxygen atom of a carbonyl group,

R are identical or different alkyl radicals having 1 to 8 carbon atoms, phenyl radicals or hydrogen atoms; and

R'' are identical or different, monocyclic or polycyclic (hetero-)arylene radicals which are optionally substituted by hydrocarbon radicals having 1 to 8 carbon atoms.

2. Process for the preparation of doped polymers, characterized in that the polymers which have been prepared by the process according to Claim 4 are treated at temperatures from 20 to 400°C and pressures from $10^{-7}$ to 2000 Pa and then dopant is added to these polymers.

3. The use of the polymers which have been prepared by the process according to Claim 1 or 2 as electrically conducting or electrically semi-conducting compounds.

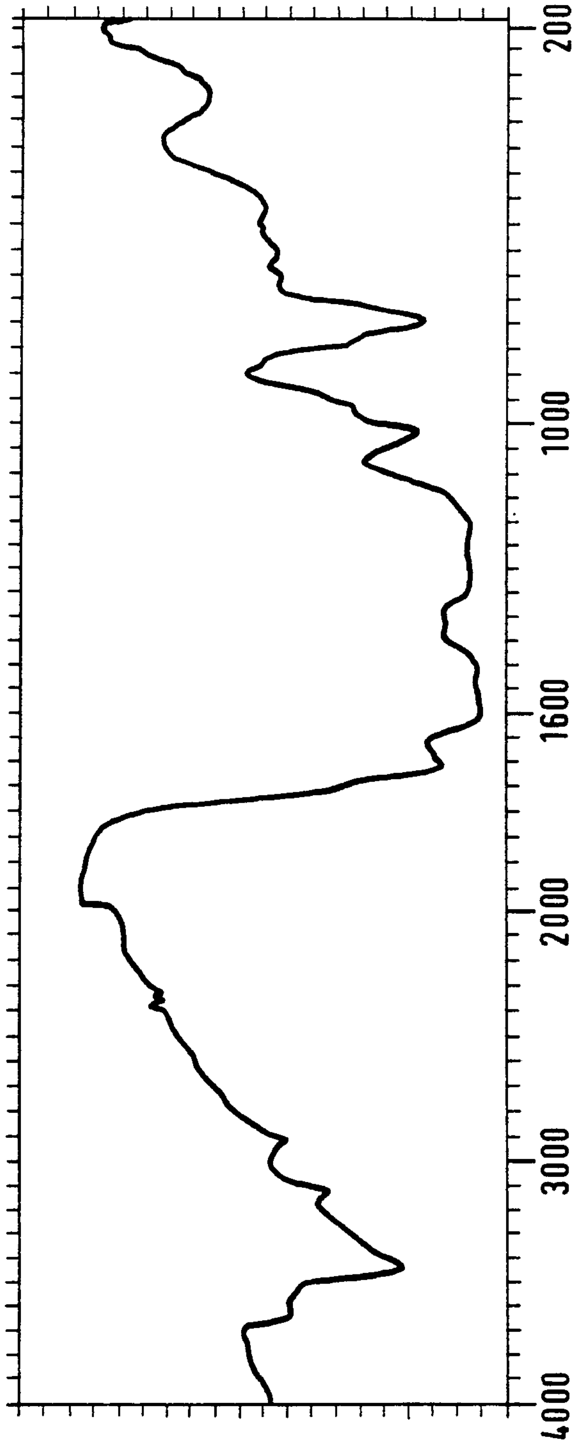


Fig. 1

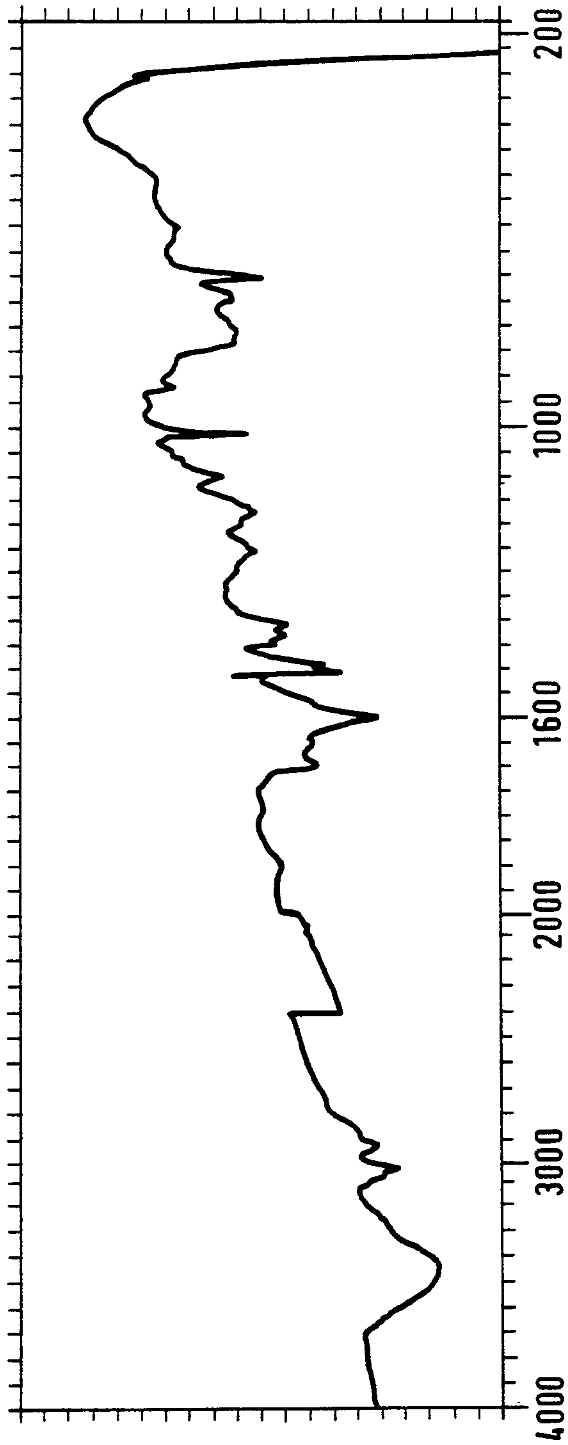


Fig. 2

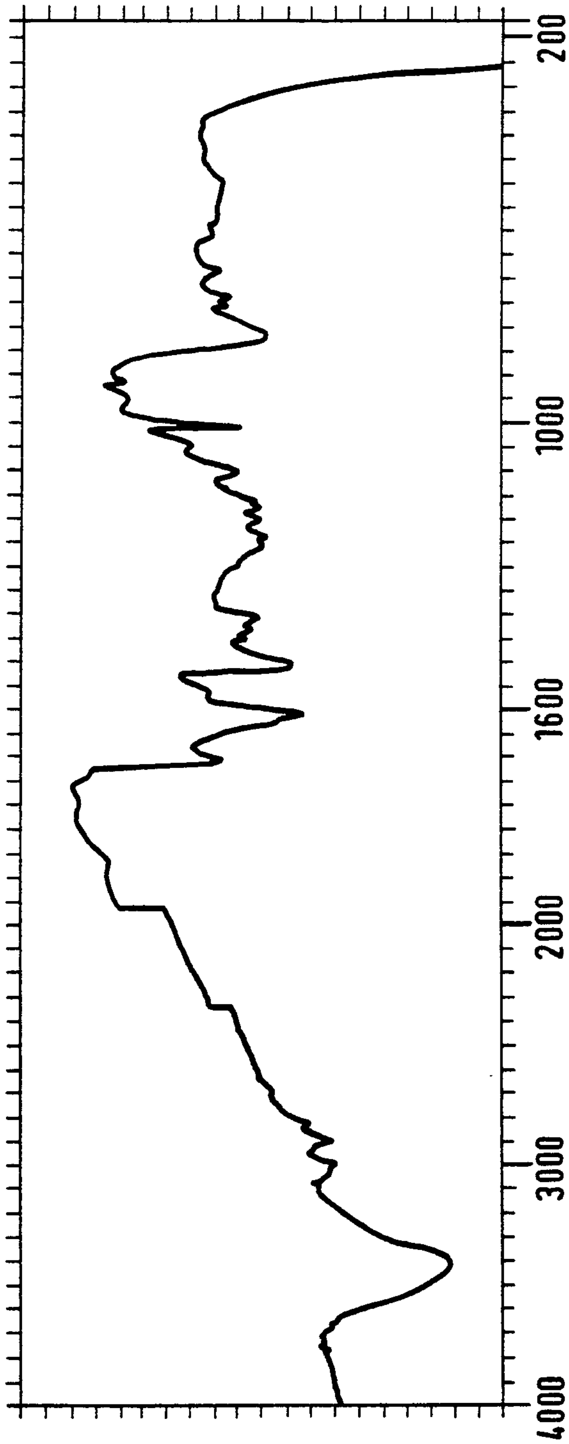


*Fig. 3*

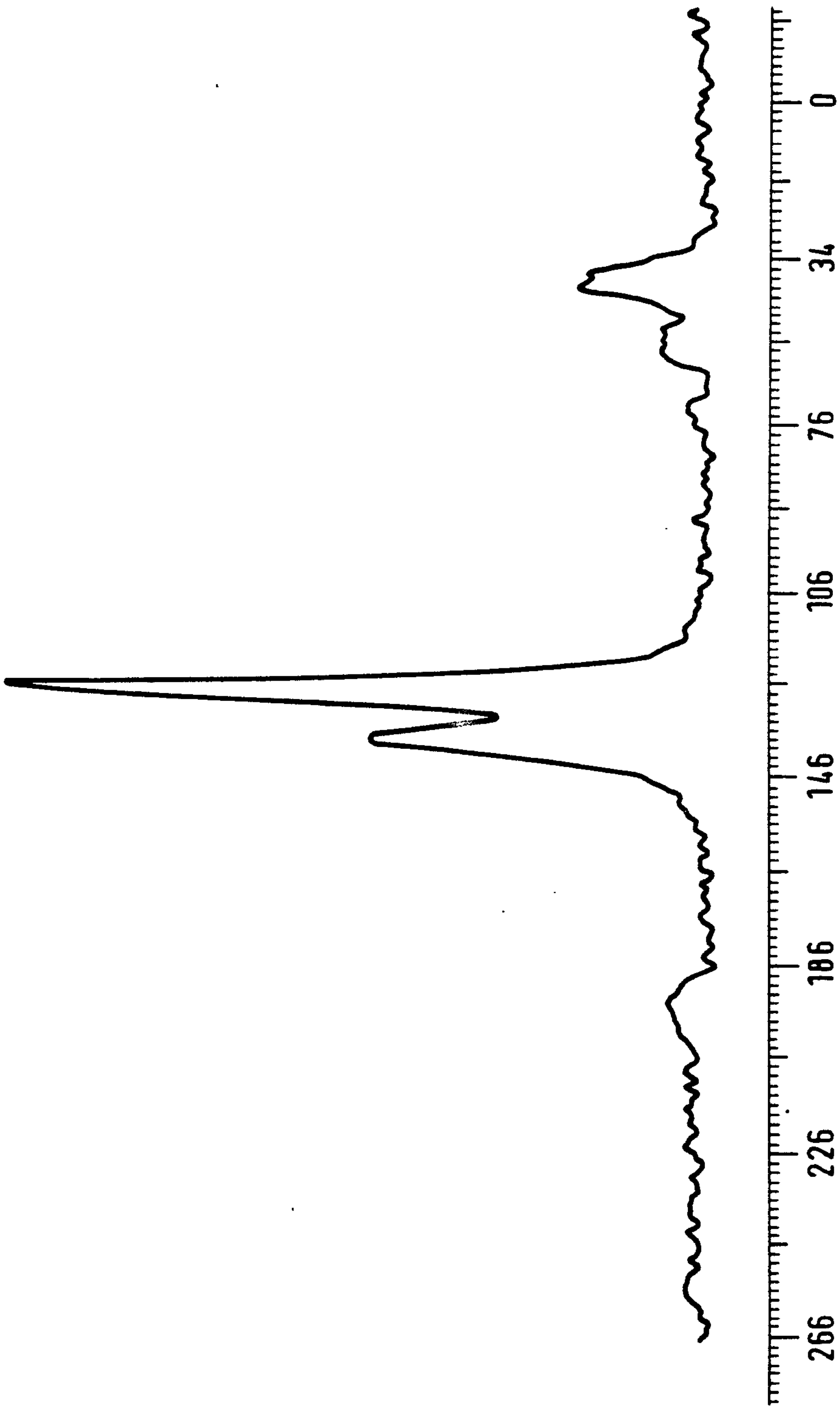


Fig. 4

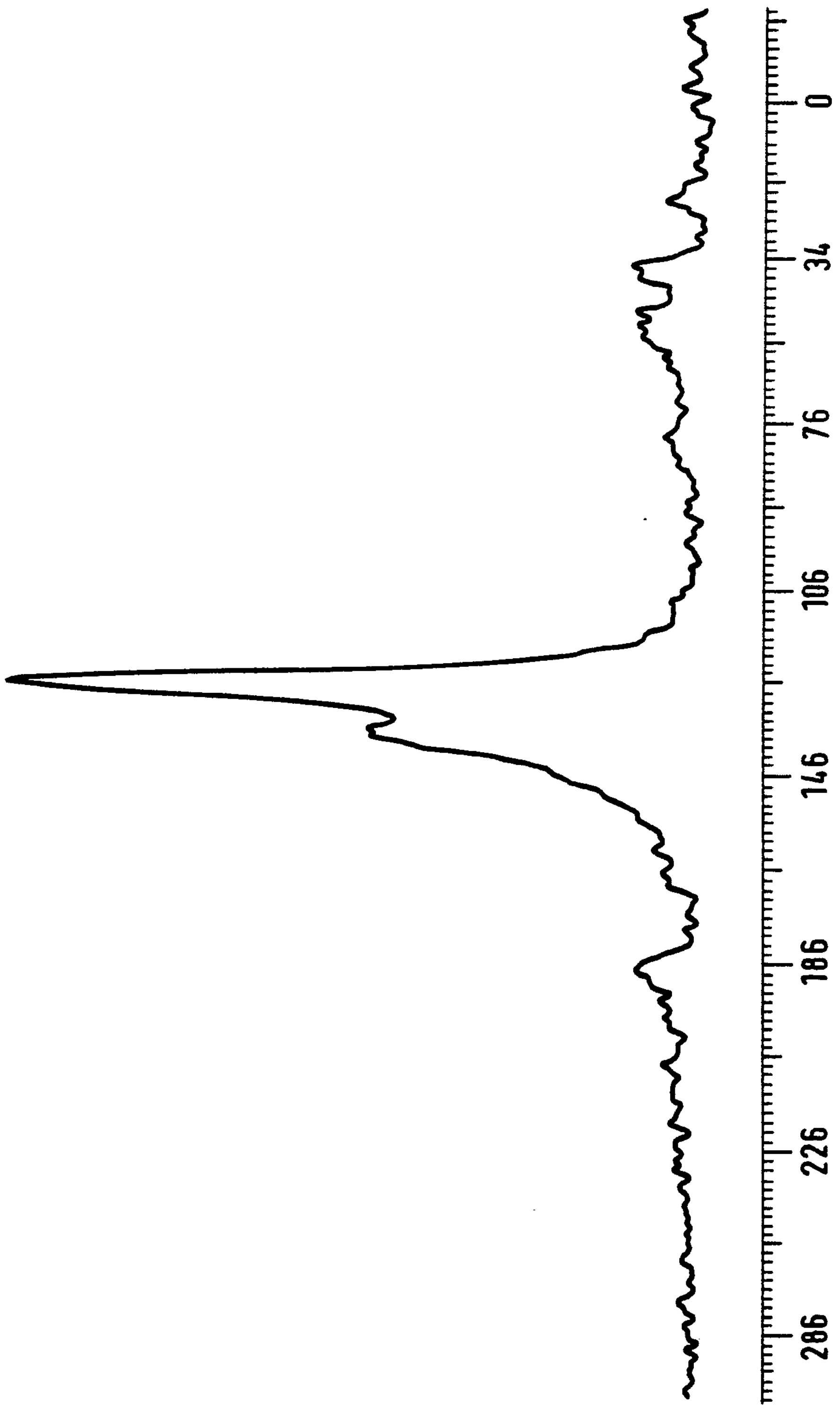


Fig. 5